Europäisches Patentamt

**European Patent Office**

**Office européen des brevets**

(19)

(11) Publication number: **0 153 010**
A1

# (12) EUROPEAN PATENT APPLICATION

(21) Application number: **85300341.6**

(22) Date of filing: **18.01.85**

(51) Int. Cl.⁴: **G 01 R 31/28**

---

(30) Priority: **25.01.84  GB 8401973**

(43) Date of publication of application: **28.08.85**
**Bulletin 85/35**

(84) Designated Contracting States: **DE GB IT NL SE**

(71) Applicant: **THORN EMI Ferguson Limited, Thorn Emi House Upper Saint Martin's Lane, London, WC2H 9ED (GB)**

(72) Inventor: **Grant, Ronald Sidney, High Green 43, Catisfield Lane, Fareham Hampshire, P015 5NT (GB)**
Inventor: **Lavender, Alan William, 60, The Links Rowner, Gosport Hampshire, P013 ODX (GB)**

(74) Representative: **Fleming, Ian Alexander et al, THORN EMI Patents Limited The Quadrangle Westmount Centre Uxbridge Road, Hayes Middlesex, UB4 0HB (GB)**

---

(54) **Circuit board testing.**

(57) In a pre-solder testing machine 1, the pcb 6 for testing, on which the electrical components 7 and 8 have been positioned but not soldered, is laid on a receiving platen 9. Then a rubber sheet 10 is laid over board 6 and the components 7, 8. Upon activation of a vacuum pump 11, air is drawn out of a compartment 12 so that board 6 is urged against platen 9 and sheet 10 is forced down against board 6 and components 7, 8 thereby holding the components in position and maintaining the vacuum. Probes 5 electrically contact the components 7, 8 to enable testing procedures to be carried out with the components 7, 8 effectively wired-up in circuit.

: 1 :

## CIRCUIT BOARD TESTING

The present invention relates to testing machinery for circuit boards with electrical components, and to a method of testing such circuit boards.

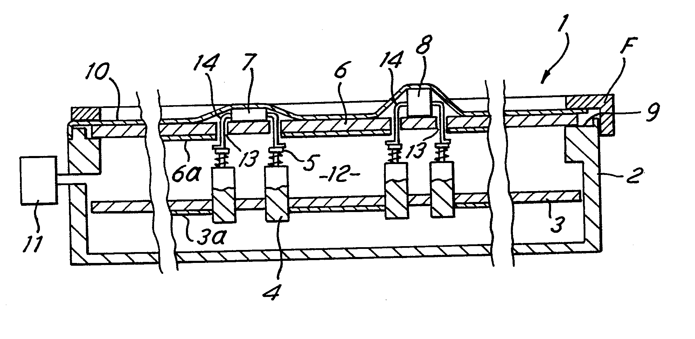

British Patent Specification No. 1591575 discloses a machine to enable the testing of a printed circuit board loaded with electrical components. The machinery has an unloaded board as a reference for testing, each of the nodes of this board having a spring-loaded pin to impinge on one of the soldered legs of the component, as evident from the Figure 7 of that document.

An object of the present invention is to provide test machinery for circuit boards holding electrical components which are not yet soldered to the boards.

The present invention provides test machinery for the testing of a circuit board with unsoldered electrical components, the machinery comprising:

means to hold a circuit board at a location for testing;

means to retain the components in position on the circuit board during the testing operation while the components are not soldered to the board; and

means to apply testing equipment to the circuit board and/or the components when the board is at the testing location.

Due to the faults being detected prior to the soldering of the components onto the boards, these faults can be rectified easily and quickly. In comparison, the testing machinery of the prior art only detected faults after the components had been soldered onto the board, thereby requiring the solder connection to be broken, and then the replacement component to be inserted and soldered onto the board. Such breaking of the solder connection and resoldering needs to be done by a skilled worker capable of careful and precise handling; even so there is a significant risk of unintentional damage occurring to neighbouring solder connections or components when rectifying faults found by machinery of the prior art.

Preferably, the retaining means acts, in use, also to effect electrical contact between the components and the means to apply testing equipment.

In one preferred form of the invention, the holding means for the circuit board includes a vacuum pump which urges the circuit board against guides which define the testing location. The retaining means may be a flexible sheet for lying against and over the components in order to urge them against the board. If such a sheet is gas-impervious and can be sealed against the board, it may contribute to the vacuum-action of holding the board at the testing location.

The sheet may have one or more indentations when in the unstressed state, the presence of such indentation(s) restricting the pressure applied to component(s) on the board.

The flexible sheet may be attached to a frame which can provide easy positioning of the sheet over a circuit board at the testing location; this arrangement can also contribute to the sealing effect between sheet and board.

In a modification to this form of the invention, the retaining means comprises a rigid plate with means to achieve a sealing effect between the plate and a circuit board at the testing location. Preferably the plate has a major surface shaped to correspond substantially to the contour of a circuit board when under test.

In a further modification to this form of the invention, there may be mechanical means (for example one or more pins) which contact with the retaining means in order to urge the components towards contact with the testing equipment, thereby to complement or replace the effect of the vacuum pump on the retaining means.

In another form of the invention, the holding means comprises mechanical means to contact with a circuit board at the testing location and to keep that board there. In this form of the invention, the holding means and/or the retaining means may comprise, for example, a flexible sheet with a support frame, or a rigid plate shaped appropriate to a circuit board with components at the testing location.

Another aspect of the present invention provides a method of testing a circuit board with unsoldered electrical components, the method comprising:

holding a circuit board at a location for testing;

retaining the components on the circuit board during the testing operation while they are not soldered to the board;

and applying testing equipment to the circuit board and/or the components when the board is at the testing location.

Preferably the method also comprises applying suction to an enclosure of testing machinery in order to hold a circuit board at a testing location of that machinery and/or to urge retaining means against the components and circuit board.

Additionally or alternatively, the method comprises applying one or more support members to abut against the components in order to urge them, during a testing operation, towards a contact position with the testing equipment. A support member may be, for example, a flexible sheet in a frame or a suitably-shaped rigid plate.

Test machinery embodying the present invention can readily be operated manually, automatically or by robot. Thus the machinery can be constructed as a stand-alone testing unit for manual or robotic placement of circuit boards for testing; alternatively the machinery can be constructed as a testing station forming part of a continuous in-line production sequence.

In order that the invention may more readily be understood, a description is now given by way of example only, reference being made to the sole accompanying cross-sectional drawing of part of a testing machine embodying the present invention.

The illustrated testing machine 1 enables tests to be made on electrical components in situ on a circuit board before they are securely fixed there by soldering. In use, machine 1 is linked to signal testing equipment which generates test signals and analyses the results. As the test machinery of the present invention requires only conventional testing equipment and standard test-signal procedures, the testing equipment has not been described or illustrated.

Machine 1 has an enclosure 2 which contains permanently a reference circuit board 3 of the type under test, reference board 3 having copper conducting tracks 3a and an upstanding test pin 4 soldered to the track(s) 3a at each point on the circuitry at which a test is to be made. Each pin 4 has an upper, spring-biassed section whose free end forms a connection probe 5. The pins are electrically connected to conventional testing equipment for generation of test signals and subsequent analysis. The board for testing is a printed circuit board 6 which is identical to reference board 3 and has tracks 6a corresponding to tracks 3a.

In use of the machine 1, the printed circuit board 6, on which the electrical components (only those designated 7 and 8 being shown) have been positioned but not soldered, is laid on a receiving platen 9. Then a 5 mm thick rubber sheet 10, attached to a sturdy frame F and secured along one edge to the platen 9, is laid over board 6 and the components. The frame F ensures that sheet 10 can readily be positioned over a circuit board at the testing location, thereby making the machine particularly suited to automatic and robotic operation in addition to manual operation. Moreover both the mass of the frame F and its right-angled section promotes the sealing effect between the sheet 10 and the board 6 and/or enclosure 2. Upon activation of a vacuum pump 11, air is drawn out of a compartment 12 in the machine 1, this compartment being bounded by enclosure 2 and the board 6 (once the latter is in position on platen 9). This suction urges board 6 against platen 9 and thereby keeps it in a precise, predetermined location intended for testing. The section also draws out the air from between board 6 and sheet 10 because apertures 13, which are in board 6 and contain legs 14 of components 7 and 8, are not blocked off by solder. Thus sheet 10 bears down on board 6 and on the components to assume a shape which follows very closely the contours of the board and components.

Then the reference board 3 is raised, by a suitable mechanism which is not illustrated, to a position in which the probes 5 (with the springs of the upper sections under tension) are touching the free ends of legs 14, so that the components are electrically connected to the electrical testing equipment. The arrangement of resiliently sprung pins 4 acting against legs 14, which are downwardly urged by sheet 10 ensures a good electrical contact; this electrical contact is further enhanced by the provision of bending over the free ends of legs 14 after insertion in apertures 13 such that these bent portions lie generally parallel to board 6.

Thus, once suction is applied sheet 10 is forced down against board 6 and components 7, 8 thereby holding the components in position and maintaining the vacuum; probes 5 electrically contact the components 7, 8 to enable testing procedures to be carried out with the components 7, 8 effectively connected up in a circuit formed by reference board 3.

While the vacuum pump is operating, not only is the board 6 kept securely at the predetermined test location, but also the sheet 10 ensures that the components remain in the correct positions on board 6 in spite of, inter alia, the spring pressure exerted by the pins 4. Another important function of sheet 10 is to provide, in effect, sealing of apertures 13, and thereby to prevent them from acting as air passageways from the atmosphere which would hence limit the ability of pump 11 holding board 6 at the test location.

Clearly, the testing equipment need not make contact with the circuit of the reference board 3 solely at the locations defined by component positions, but can be connected at additional locations of the reference board 3.

In a modification, sheet 10 is shaped such that in its unstressed state it has a generally planar lower surface which has an indentation at each place which would overlie, in use, one of the tall components (of which only one, 8, is shown). In this way the sheet does not exert excessive pressure on the tall components. By suitable arrangement of different sized indentations, a sheet can exert a substantially identical pressure on each of a number of components having a wide range of heights. Alternatively, the indentations can be replaced by areas which have increased flexibility in order to accommodate the tall components.

In another modification, sheet 10 is replaced by an inflexible support plate whose underside (i.e. that side to contact the board and components) has a preformed shape corresponding to the contours of the board and components. The support plate can be held in position during the testing operation by the suction effect of the vacuum pump, or by mechanical fastening or by a combination of each; in each of these circumstances, of course, the board under test must be held against the machinery, for example by suction or mechanically (e.g. for the latter, by using one or more appropriately-positioned pins). If considered appropriate, the support plate can have a device to provide sealing between the plate and the board 6 and/or enclosure 2.

In a further modification, an appropriate arrangement of pins replaces the sheet 10 or plate in respect of acting on the components to retain them in position on the board and to urge them to connect with the testing equipment.

In another modification, the testing machine has a number of separate platens 9 each for a circuit board, whereby a number of circuit boards (whether of identical or different circuitry) can be tested simultaneously.

A circuit board and associated components can be transported over large distances much more securely when in the unsoldered state than in the soldered state. This is primarily because the loose connection between component and board when in or the unsoldered state ensures that any impacts on a component will not produce a significant risk of damage to the component itself or to an electrical connection in the circuit. Thus the present invention is suitable for a manufacturing operation whereby a circuit board and components are assembled together and tested in the unsoldered state, then transported significant distances in the unsoldered state (e.g. between different factories) before the soldering operation is done. Advantageously the component ends are bent over (as described above) before transportation, in order to avoid component legs withdrawing from the appropriate apertures.

: 8 :

## CLAIMS

1. Test machinery for the testing of a circuit board with unsoldered electrical components, the machinery comprising:

means to hold a circuit board at a location for testing;

means to retain the components in position on the circuit board during the testing operation while the components are not soldered to the board;   and

means to apply testing equipment to the circuit board and/or the components when the board is at the testing location.

2. Test machinery according to Claim 1, wherein the retaining means acts, in use, to effect electrical contact between the components and the means to apply testing equipment.

3. Test machinery according to Claim 1 or Claim 2, wherein the retaining means comprises a flexible sheet to lie against and over the components and to urge them against the circuit board.

4. Test machinery according to Claim 3, wherein the retaining means further comprises a frame to which the flexible sheet is attached.

5. Test machinery according to Claim 1 or Claim 2, wherein the retaining means is a rigid plate having means to achieve a sealing effect between the plate and a circuit board at the testing location.

6. Test machinery according to any one of Claims 3 to 5, wherein the sheet or plate is made of substantially gas-impervious material and can be sealed against a circuit board at the test location.

7. Test machinery according to any one of the preceding Claims, wherein the holding means includes a vacuum pump to contribute to urging of the retaining means against the circuit board during the testing operation.

8. A method of testing a circuit board with unsoldered electrical components, the method comprising:

holding a circuit board at a location for testing;

retaining the components on the circuit board during the testing operation while they are not soldered to the board;

and applying testing equipment to the circuit board and/or the components when the board is at the testing location.

9. A method according to Claim 8, comprising applying suction to an enclosure of testing machinery in order to hold a circuit board at a testing location of that machinery and to urge retaining means against the components and circuit board.

10. A method according to Claim 8 or Claim 9, comprising applying one or more support members to abut against the components in order to urge them, during a testing operation, towards a contact position with the testing equipment.

0153010

1/1

European Patent Office

**EUROPEAN SEARCH REPORT**

0153010

Application number

| | **DOCUMENTS CONSIDERED TO BE RELEVANT** | | EP 85300341.6 |
|---|---|---|---|

| Category | Citation of document with indication, where appropriate, of relevant passages | Relevant to claim | CLASSIFICATION OF THE APPLICATION (Int. Cl.4) |
|---|---|---|---|
| Y | <u>DE - A1 - 3 201 472</u> (EVERETT)<br>* Fig. 5 * | 1-10 | G 01 R 31/28 |
| | | | |
| Y | <u>US - A - 4 108 528</u> (LONG)<br>* Fig. 3 * | 1-10 | |
| | ---- | | |

| | TECHNICAL FIELDS SEARCHED (Int. Cl.4) |
|---|---|
| | G 01 R 31/00<br>H 01 L 21/00 |

The present search report has been drawn up for all claims

| Place of search | Date of completion of the search | Examiner |
|---|---|---|
| VIENNA | 20-05-1985 | KUNZE |